# EUROPEAN PATENT APPLICATION

(11) **EP 0 622 683 A1**
(43) Date of publication of application: **02.11.1994**
(21) Application number: 94105707.7
(22) Date of filing: 13.04.1994
(51) Int. Cl.: G03F 7/095

(54) **Resist structures having through holes with shaped wall profiles and fabrication thereof**

(30) Priority: 30.04.1993 US 56008
(71) Applicant: International Business Machines Corporation, Armonk, N.Y. 10504 (US)
(72) Inventor: Kordus, Mark Richard, Pleasant Valley, New York 12569 (US); Krongelb, Sol, Katonah, New York 10536 (US); Pfeiffer, Aloysius Thomas, Sun City Center, Florida 33573 (US); Romankiw, Lubomyr Taras, Briarcliff Manor, New York 10510 (US); Berkenblit, Melvin, Yorktown Heights, New York 10598 (US)
(74) Representative: Schäfer, Wolfgang, Dipl.-Ing.

(57) **Abstract**

A high sensitivity resist layer structure for high energy radiation exposure is formed by coating plural layers of radiation degradable polymers on a substrate which layers have a different cross-link density and thereby have different solubility in the resist developer. Upon exposure and solvent development, a resist edge profile is obtained which can have a predetermined shape.

## Description

### FIELD OF THE INVENTION

This invention relates generally to resist layer structures and more particularly to high sensitivity positive resist layers useful in high energy radiation exposure processes.

### BACKGROUND OF THE INVENTION

The formation of positive resist masks from layers of radiation degradable polymers is described, for example, by Haller and Hatzakis in U.S Patent No. 3,535,137. In this process a radiation degradable polymer layer is coated on a substrate and is subjected to patternwise exposure to high energy radiation such as, for example, x-rays, nuclear radiation, and electrons. The irradiated regions of the polymer suffer a decrease in molecular weight and thereby become more soluble. A developer is then used to preferentially remove the irradiated portions of the layer. The substrate can then be subjected to an additive or subtractive process such as metallization or etching with the remaining portions of the resist layer protecting the substrate from the processing.

US Patent 3,934,057, a high sensitivity resist layer structure for high energy radiation by coating plural layers of polymethyl methacylates radiation degradable on a substrate. The layers in a direction away from the substrate surface are successively slower, dissolving in a resist developer. The variation solubility in the developer is achieved by depositing a lower molecular weight polymethylmethacrylate first and depositing a second layer of polymethylmethacrylate having a higher molecular weight. A lower molecular weight polymer has a shorter chain length than a higher molecular weight polymer and is therefore more soluble.

IBM Technical Disclosure Bulletin describes forming pattern of varying sidewall shape in a thick resist by depositing a plurality of layers of resist and exposing each resist layer to a pre-exposure radiation to modify the solubility of each layer.

The sensitivity of the resist layer can be defined by the ratio S/S 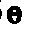 where S is the solubility rate of exposed resist for a given exposure dosage and S 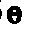 is the solubility rate for the unexposed resist. A S/S 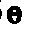 ratio of at least 2.0 is required to obtain a pattern so that a sufficient unexposed resist layer thickness remains after development The larger the S/S 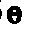 ratio the sharper the developed image. Positive working resists generally have S/S 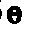 > 10 and usually 13. The larger is this ratio the greater will be the fidelity of the developed pattern. The closer will be the dimensions of the top layer of the pattern to the dimensions of the mask used for the exposure of the pattern.

Another factor involved in the use of high energy radiation to exposed resist layers is the fact that there are certain advantage to the use of, for example, electron beams of increasing energy, for example, 10 to 50 kilovolts (KV). This has the advantage of decreasing writing times for a resist because higher amps/per square centimeter can be produced by the electron gun and the higher energy beams also provide more back scatter electron signal for better registration and detection. However, it has been found that for any given resist thickness employed, the higher energy beams produce less electron scattering and undercutting of the resist such that excessive exposure times would be required to obtain the desired undercut profile by exposure alone.

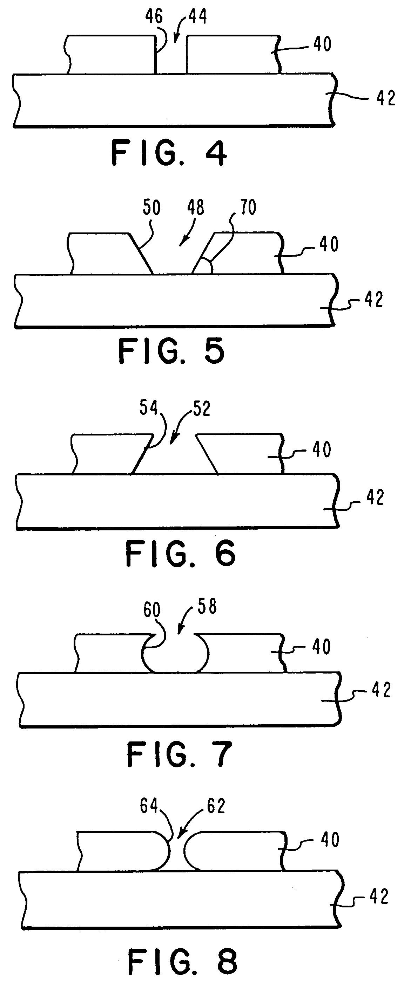

Wall profiles of novolak matrix resins with dispersed diazoquinone photoactive compounds, for example, AZ resists, (supplied by Shipley, Hoescht, Dynachem, etc.) thicker than 1 µ exposed in a typical commercial contact or projection printer upon development assume a "V" shape as shown in Figure 5. The angle 70 which the V shaped wall profiles form with the substrate is usually ∼ 70° to 80°. Under ideal conditions angle 70 may be as high as 85°. The angle of the profile depends on such variables as: mask quality, exposure time, degree of culmination of exposing irradiation, intimacy of contact between the mask and resist, predevelopment baking time and temperature, post development baking time and temperature, the development time, temperature, and concentration of the developing solution and numerous other factors. Under optimum conditions the angle ϑ may approach 85°, but can never be ≧ 90° in conventional resist processing.

In the case of wet chemical etching the wall profile of the resist has no direct effect on the etched line width or the profile of the etched pattern. In the cases of dry etching, sputter etching, ion milling, reactive ion etching and plasma etching where the resist is being etched simultaneously while the underlying material is being etched. The initial profile of the resist can very strongly affect the quality of the pattern being formed, the width of the pattern, the wall profiles, the presence of the redeposited material, troughing etc. Particularly in sputter etching, ion milling and reactive ion etching the resist profile degrades very rapidly with etching time. The metal pattern sidewall profile is more sloping, i.e., the angle is smaller than that of the resist. If the starting resist profile is 75°, the resulting metal or dielectric profile will be < 60°. For this reason, to obtain the steepest walls the highest packing density it is desirable to have a near 90° resist profile.

In many situations, it is desired to have the initial resist wall profiles with ϑ ≧ 90°; i.e., to have a vertical wall profile, over hanging T shaped wall profiles or the inverted V shaped profiles in resist usually much thicker than 1 µ and often even up to several hundred microns thick.

### SUMMARY OF THE INVENTION

An object of the present invention is to provide improved resist structures and methods of fabrication thereof.

It is another object of the present invention to provide an improved resist structure and methods of fabrication by providing a non-uniform complexation density or a varying degree of complexation to the resist structure and thereby a variable solubility through the resist thickness.

It is yet another object of the present invention to provide resist structures and methods of fabrication thereof, having through holes with shaped sidewalls.

It is a further object of the present invention to provide resist structures and methods of fabrication thereof which are formed from a plurality of sublayers each having a different degree of complexation of resin and energy active compound.

It is an additional object of the present invention to form thick layers of resist on top of each other without erasing the previous layers.

It is yet an additional object of the present invention to develop a pattern of predetermined sidewall shape in a layer of resist having a thickness greater than 20 microns.

It is yet a further object of the present invention to expose very thick layers of resist while maintaining the ability to achieve a vertical sidewall profile or undercut profile upon development.

It is still another object of the present invention to form a pattern in thin and thick layers of resist without the presence of a typical "foot" at the resist substrate interface which affects resist resolution.

A broad aspect of the present invention is a body of resist having a varying degree of complexation of the resist components.

In a more particular aspect of the present invention, a resist structure is formed from a layer of resist having a first side and a second side, the resist layer has a varying degree of complexation between said first side and said second side.

In another more particular aspect of the present invention, the layer of resist is formed from a plurality of sublayers each having a different degree of complexation of the resist components.

In another more particular aspect of the present invention, the resist structure has an aperture having a sidewall with a predetermined shape.

In another more particular aspect of the present invention, the resist structure has a sidewall angle from 10° to 170°.

Another broad aspect of the present invention is a method of disposing on a substrate a body of resist having a varying degree of complexation of resist components.

A more particular aspect of the method of the present invention is providing a layer of resist having a first side and a second side and having a varying degree of complexation between said first side and said second side.

Another more particular aspect of the method of the present invention is the application of successive sublayers of resist without subsequent redissolution or erasure of the previously applied layer.

Another more particular aspect of the present invention is disposing on a substrate a layer of resist formed from a plurality of sublayers each having a different degree of complexation.

Another more particular aspect of the method of the present invention is forming an aperture in the resist having a sidewall with a predetermined shape.

### BRIEF DESCRIPTION OF THE DRAWINGS

The foregoing and other objects, features and advantages of the invention will be apparent from the following more particular description of the preferred embodiments of the invention as illustrated in the accompanying drawings.

Figure 1 is a schematic representation of a complexed resist.

Figure 2 shows a resist layer preferably comprised of a plurality of sublayers.

Figure 3 shows a schematic plot of the degree of complexation versus depth into the resist layer of Figure 2.

Figure 4 shows a straight aperture having straight and parallel sidewalls in a resist layer.

Figure 5 shows an aperture having straight "V" shaped sidewalls in a resist layer.

Figure 6 shows an aperture having straight and "inverted V" shaped sidewalls in a resist layer.

Figure 7 shows an aperture having concave rounded sidewalls in a resist layer.

Figure 8 shows an aperture having a concave rounded sidewall in a resist layer.

Figure 9 shows an aperture having vertical wall shape in a resist layer.

Figure 10 shows an aperture having a "T" shape in a resist layer.

### DETAILED DESCRIPTION

A technique for shaping wall profiles in resist in ultraviolet, deep ultraviolet, electron beam, and x-ray lithographies by chemical modification of resists is described herein.

High resolution wall profiles in resists can be shaped by coating substrates with several layers of resist without erasing previously applied layers and by chemical modification of the layers of the resist such that selected layers are more readily dissolved (solubilized) by the developer than others. Possible wall profiles range from V shape (typical wall profile obtained in thick positive working resist), to: vertical wall, inverted V shape with overhang, T shape, S shape, irregular shape or very low sidewall angle V shape.

The technique comprises:
1. Adding a substance to a resist which either (a) slows down or (b) speeds-up the etching rate by the developer of the undeveloped resist.
2. Spinning on the layers of resist (treated to have different solubility rates in either the exposed or the unexposed state) in order, so that upon development, the desired profile results. Redissolution of or diffusion of resist into previously applied sublayers is minimized by baking the resist between each resist application (the resist layer can be applied by an known method, such as roller coating, spraying, dipping, etc) above about 80°C but below about 110°C and by partially flooding the substrate with resist and then immediately commencing spinning to distribute the resist. Alternatively, each resist layer is baked at from about 80°C to 110°C, preferably from about 80°C to about 90°C in vacuum to minimize the amount of the remaining solvent in the case resist and particularly in the top surface of the resist layer. Alternatively, the next resist layer is applied while slowly spinning the wafer and upon reaching of the edges of the wafer the spinning speed is increased. Alternatively, the viscosity of each subsequent resist layer is selected so that subsequently layers have a higher viscosity.
3. Exposing the resist for a predetermined time to the ultraviolet radiation, e-beam, deep ultraviolet, or x-ray radiation. It is preferable that this exposure be longer or at a higher intensity, than for the resist containing the same amount of complexing agent.
4. Developing the exposed resist sample for a predetermined length of time to obtain a vertical wall profile or for a time in excess of that required for vertical wall in order to obtain an overhanging wall profile, inverted V shape, or T shape.

If necessary, the resist can be treated by any other chemical means which result in the desired profile by altering the thickness of the resist. Also, after development, the unexposed resist can be subjected to a chemical solution, gas, vapor or plasma which dissolves some layers at a higher etching rate than the others to yield the desired profile.

A similar result can be accomplished by treating the resist by any other substance, which, without adversely affecting the resist behavior (flow characteristics, sensitivity to radiation, attack by etching or plating solutions, etc), either speeds up or slows down the rate of dissolution of resist by the developer solution, or by any other solution to which the developed pattern is subjected, in either the unexposed or in the exposed state, and in the developed or the undeveloped state. As an example of additives to the resist, one can use a variety of surfactants, solvents, monomers and polymer organic varnishes, which are mutually soluble with the resist which has a very small effect on the solubility of the exposed resist by have a pronounced effect, such as, slowing down or speeding up the dissolution rate of the unexposed positive working resist or slowing down or speeding up the solubility of the exposed resist.

The basic concept is equally applicable to all other positive, as well as negative working resists, regardless whether used in liquid form or in a precast film form. In the case of the precast resist, the modification has to be done prior to casting of the resist, during casting, or by proper treatment after casting.

Furthermore, this invention is not limited to the ultraviolet sensitive resists, but is equally applicable to the electron sensitive, deep ultraviolet sensitive, and X-ray sensitive resists. Therefore, electron and X-ray sensitive resists such as PMMA (polymethyl metacrylic acid) or PMMA-copolymer can be prepared in a variety of solutions; each solution having progressively faster or slower solubility rate in the developer or a post development solvent in either the exposed or unexposed state. Such increase in the development rate can be achieved by using progressively less complexed PMMA layers or by adding progressively more terpolymer to the PMMA.

In addition, the layers can be spun in any desired order. However, if the most soluble resist is on the bottom and least sensitive is on the top, upon exposure one will quite readily obtain a large height to width aspect ratio and vertical wall profile or overhang.

The range of wall profiles are achievable by modifying the solubility of the resist resin. By addition of appropriate amounts of certain additives the intermolecular bonding or complexation (such as through covalent bonding, ionic bonding and hydrogen bonding) of the additive and base resin is enhanced. This higher level of bonding causes the resin to be less soluble in the developer than the base resin with no additive. By varying the degree of complexation the degree of solubility is varied and with proper application of the sublayers the wall profile can be controlled. Some additives are not photosensitive, such as HMDS (hexamethyldisilazane). Other additives are photosensitive, for example, diazoquinone, orthonaphoquinone, and benzophenone. Other additives are sensitive to electron beams and x-rays. Numerous energy sensitive additives are known in the art.

Additive compounds are used in resist to provide sensitivity to energy (such as light, electron beam and x-rays). These are referred to herein as energy active compounds or as photoactive compounds (PAC). The PAC material plays a dual role. first it is hydrophobic and has low solubility in aqueous solutions and second upon hydrogen bonding, covalent bonding or ionic bonding with the base resin (which is hydrophobic) it decreases the resist solubility in aqueous solutions. Upon exposure to energy (such as a certain wavelength of radiation) the PAC material can transform into an acid (a hydrophilic material) which easily dissolves in aqueous solutions and allows the base resin to again dissolve in the same solution.

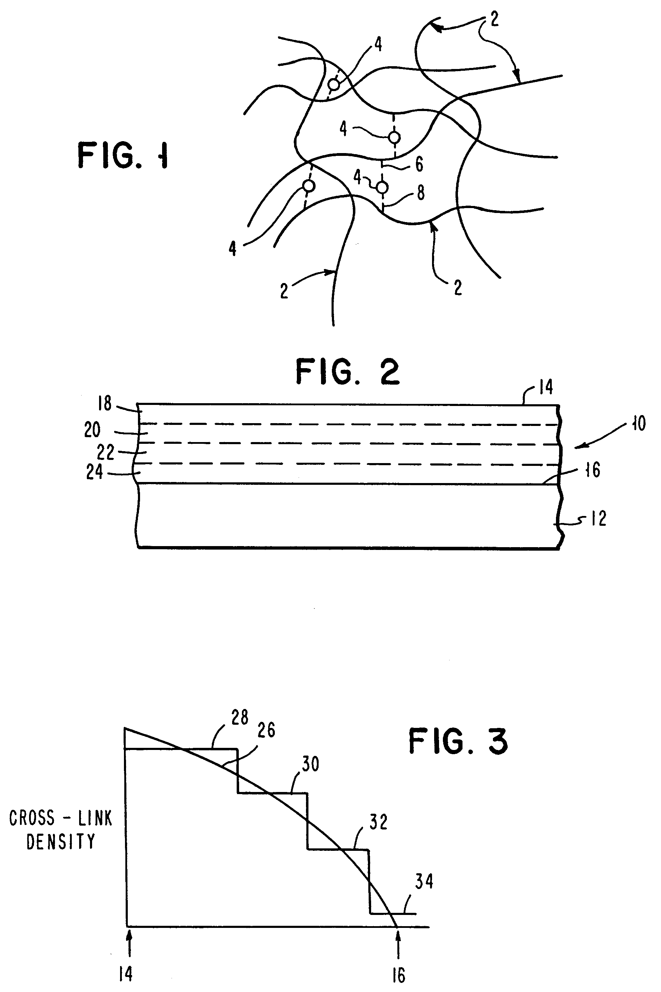

Figure 1 schematically shows a group of polymer molecules 2 complexed by complexing agent 4 which is complexed between two polymer molecules by bonds 6 and 8 which can be covalent, ionic or hydrogen bonds.

A predetermined sidewall profile of a through-hole or pattern in a resist can be achieved by varying the level of the energy active compounds or PAS in the sublayers.

In the preferred embodiments of the inventions herein, the resist materials in the liquid uncured form are preferably an admixture of a solvent, a first resin, a photoactive compound and a second resin having no photoactive compound. The degree of complexation (and correspondingly the solubility) of the admixture is controlled by varying the amount of the second resin. This changes the net concentration of the photoactive compound (energy active compound) and correspondingly the degree of complexation and solubility.

Figure 2 is a schematic diagram of a layer 10 of resist on a substrate 12. Figure 3 is a schematic plot 26 of the cross-link density versus the distance from surface 14 (top surface) to surface 16 (bottom surface) of resist layer 12. In the preferred embodiment, this is achieved by having a plurality of sublayers 18, 20, 22 and 24 shown bounded by dotted lines on Figure 2. (Four sublayers are exemplary only) Each sublayer 18, 20, 22 and 24 has a fixed cross-link density 28, 30, 32 and 34 respectively, as shown in Figure 3. In the preferred embodiment, these fixed cross-link densities are achieved by controlling the concentration of the photoactive compound by the addition of a novolak resin without the photoactive compound. This is a particularly inexpensive process since commercially available materials can be used. For example, Shipley AR resist 1350, 1350J, 1350H, Z401, C0275, 2300, 4600, etc. can be used as the resist with a photoactive compound and Alnoval, made by Hoeclite Co. Inc, can be used as the resin without the photoactive compound. In addition, for further control of the cross-link density, HMDS which is not photoactive or a resin but a cross-linking agent can be added for further control of the cross-link density. Examples of a nonphotoactive complexing agents are hexamethyldisilazane (HMDS) xylene, toluene, chlorobenzene, Triton X-100, Triton N (Rom & Haas Co.) IC 170C (3M Company), etc.

Figures 4 to 8 show examples of apertures having sidewall shapes in a resist layer according to the present invention. Figure 4 shows an aperture 44 having straight and parallel sidewalls 46. Figure 5 shows an aperture 48 having straight and "V" shaped sidewalls 50. Figure 6 shows aperture 52 having straight and "inverted V" shaped sidewall 54. Figure 7 shows aperture 58 having curved (concave) or bow shaped sidewall 60. Figure 8 shows aperture 62 having hour-glass (convex) sidewall 64.

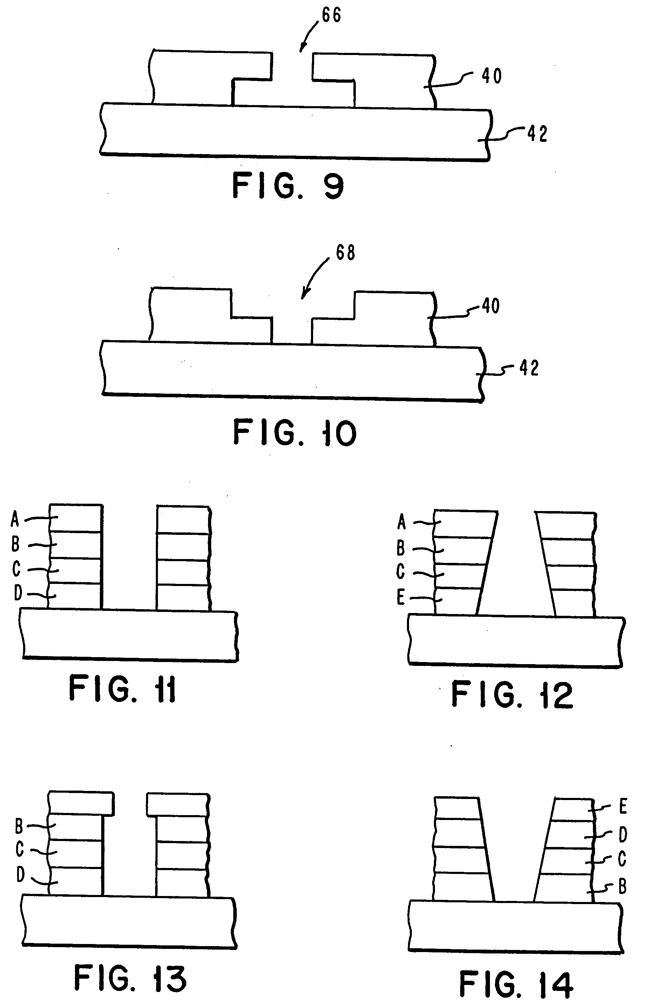

Described herein are techniques for sculpturing the wall profiles in 1 µ to 100 µ thick resist (such as AZ resist) to nearly any desired profile with the angle ϑ in the range 45° < ϑ < 135°, with a T type 66 overhang as shown in Fig. 9 a inverted "T" shape 68 as shown in Figure 10. In addition to permitting shaping the profiles as described, the technique permits obtaining patterns in thick novolak resist, using Karl Siiss Model 150m or Perkin Elmer lithography tool with the quality of the lithography approaching the patterns usually obtained by conformable deep UV technique, e-beam, or x-ray lithographies.

The preferred technique, which we developed, consists of:
1. Preparing a number of novolak resists whose rates of etching, in either the exposed or unexposed state, differ from each other by a desired amount,
2. Applying the different novolak resists in layers, on top of each other, without erasing the layers underneath,
3. Exposing the composite resist structure for a predetermined length of time through a mask,
4. Developing the composite resist structure in the standard AZ resist developer for a predetermined length of time.

While the profile of the exposed resist composite is controlled mainly be selecting the proper order in which the different resist with different etching rates are applied, a considerable latitude of control over the resist profile can be exercised also during the development of the resist and during exposure.

The technique has been used Successfully to form 1 µ T and I bar patterns in 1 µ thick modified AZ 1350 resist with perfectly vertical walls and also to form the inverted V type and T type overhangs in 2 µm, 6 µm, 35µm, 60µm and 100µm thick modified Shipley 1350 resists. In all cases the resist patterns were used to successfully form metal patterns by electroplating or lift-off.

Figures 4 to 8 demonstrates the variety of profiles which are possible to form in the modified novolak resist using conventional alignment and exposure apparatus.

We have developed a technique which permits to use a typical commercial alignment and exposure apparatus such as Karl Siiss Model 150m or Perkin Elmer or similar machine and regular chrome or emulsion masks (on 60 mil thick glass) and obtain very high resolution patterns with controlled profiles in very thick resist. The wall profiles which we obtained range from V shape (typical wall profile obtained in thick positive working resist), to vertical walls to inverted V shape with overhang, shape or even S shape profile. The vertical wall, inverted V shape and T shape are useful in lift-off processes and in the through mask plating processes where very high pattern densities, with large height to width aspect ratio are desired. The invention consists of:
1. A new technique for building up of a thick novolak resist, e-beam, or x-ray resist, consisting of the application of several layers of resist on top of each other without erasing the previous resist.
2. Chemical modification of resist in a way such that some layers (as desired) are more readily dissolves by the developer than others.
   The technique, in which resist modification is done, consist of:
   a. Adding a substance to the resist which either (a) slows down or (b) speeds-up the etching rate by the developer of the unexposed resist.
   b. Adding a substance to the resist which either (a) speeds up or (b) slows down etching rate of the developed resist.
   c. Combination of (a) on top and (b) on the bottom using resist treated with a substance which speeds up dissolution of the exposed resist and on the top using resist treated with the substance that retards dissolution rate of the unexposed resist.
3. Spinning on the layers of resist (treated to have different solubility rates in either the exposed or the unexposed state( in an order so that upon development a desired profile would result i.e., a vertical wall, 90°; 100° wall profile (inverted V shape); 135° wall profile, or a vertical wall with T shaped overhang. Erasure of each subsequent layer of resist is minimized by 1) stabilizing after spinning and 2) partial flooding of the wafer with resist and then quickly commencing the spinning of the resist.
4. Exposing the resist for a predetermined time to the UV radiation, e-beam radiation, deep UV, or x-rays.
5. Developing the exposed resist sample for a predetermined length of time to obtain a vertical wall profile or V shape, or inverted V shape profile depending on the resist sublayers.
   If necessary additionally:
6. Treating the resist by any other chemical means which result in the desired profile through the thickness of the resist.
   or if necessary, additionally:
7. After development subjecting the unexposed resist to a chemical solution, gas, vapor or plasma which dissolves some layers at a higher etching rate than the others.

Examples of such modification of the resist are:
(1) In case of AZ 1350 J resist Alnoval 320K (manufactured by Hoechst Co.) formaldehyde resin as 20% solution in 2-ethoxy ethyl acetate or ethyl lactate to AZ 1350 J resist. Addition is done in quantities of ∼ 10, 20 or up to 50% by volume. Addition of Alnoval 320K makes the exposed resist etch at a faster rate than the untreated unexposed resist.

Typical examples are:

### Example I

Solution I: AZ 1350 J
Solution II: AZ 1350 J + 20% Alnoval 320K phenol formaldehyde as 20% solution in 2-ethoxy ethyl acetate or ethyl lactate. Where solution II develops faster in both exposed and unexposed state.

Mix Solution I and II in following proportions of I:II by volume
A 4:0
B 3:1
C 1:1
D 1:3
E 0:4
Spin solutions A,B,C,D and E in the order in which it is desired, to produce either the vertical wall, inverted V, T shaped or V shaped wall as shown in Figures 9, 10, 11 and 12 respectively.

After exposure, develop in the Shipley 2401-CD275 the exposure conditions depend on the resist thickness and is within the skill of the art to determine for a particular application.

If the order is E on the bottom and A on the top, proper development will generate an inverted V shape (Figure 12). If the order is E on top and B on the bottom, proper development will generate V shape (Figure 14). If the order is A,B,C,D from top to bottom, proper development will generate a 90° wall profile (Figure 11). In all cases proper development times generate the indicated wall profile with the best replication of mask dimensions. Exemplary conditions for Shipley P-9 19-44 resist at 35 microns thickness are: exposure of 1210 mJ/Km² development in Shipley 2401-CD275 for 1 minute at 22°C.

From the teaching herein, it will be apparent to one skilled in the art that the order of application of solutions A, B, C, D and E can be changed, substituted, altered, certain solutions can be omitted i.e., can only use (A) + (E), or (A) + (D) with either (A) or (E) on top, or (A) or (D) on top of (E) depending on the desired final profile.

### Example II

Similar results can be obtained by using the high contrast TNS resist in combination with 20% Varcum 6000-1 resin in diglyme solvent. In this example we have prepared resists in a similar way, have applied resists in layers in a similar way, and upon development were able to similarly control the profiles of the exposed resist as in example (I). In this resist, as required by the resist, the prebake temperature was 90°C rather than ∼ 70°C.

The same final result can be accomplished by treating the resist by any other substance, for example, xylene, benzene, chloro benzene, toluene, Triton-N, TritonX-100 (Rolm and Haas Co.) FC95 (3M Company), which, without adversely affecting the resist behavior (flow characteristics, sensitivity to radiation, attack by etching or plating solutions etc) would either speed up or slow down the rate of dissolution of resist by the developer solution, or by any other solution to which the developed patterns is subjected, in either the unexposed or in the exposed state, and in the developed or the undeveloped state. Examples of developer solutions are tetramethyl ammonium hydroxide and potassium hydroxide.

As an example of additives to the resist one can use a variety of surfactants, solvents, monomers and polymeric organic varnishes, which are mutually soluble with the resist and do not affects its properties mentioned above. From the family of surfactants we have used: Triton X-100, Triton N (manufactured by Rolm and Haas Co.) and FC170 (manufactured by Rolm and Haas Co.)
The use of 3M Company FC 170 surfactant in the Shipley 1350 J resist This surfactant decreases the rate of etching of unexposed resist by a factor > 2 thus producing substantial overhangs.

Based on these examples it is apparent that with the proper combination of addition agents or proper treatment of the resist with other substance it is possible to produce patterns with almost infinite height to width aspect ratios and with:
(a) perfectly vertical walls
(b) inverted V shaped walls
(c) bulging "S" shaped walls, convex, concave or any other desired shape.

It is also apparent that the invention is not limited only to the novolak family of resists. The basic concept is equally applicable to all other positive, as well as negative working resists, regardless whether used in varnish form or in a precast film form such as Riston&registered. (Trademark of DuPont Company). In case of the precast resist the modification has to be done prior to casting of the resist, during casting, or by proper treatment after casting.

While the most widely used resist are those based on novolak resins, imageable resists can also be formulated with other resins. It should be understood that the principles of this invention also apply to such materials.

Examples of resins which have been used in resist formulations include polyhudroxystyrenes, polyvinylphenol, styrene-methacrylic acid, PMMA-methacrylic acid, esterified polyvinyl alcohol, polyimide and silylated novolak.

Furthermore, it is apparent to one skilled in the art that this invention is not limited to the UV sensitive resists, but is equally applicable to the electron sensitive, deep UV sensitive and x-ray sensitive resists. Therefore electron and x-ray sensitive resist, such as PMMA or PMMA-copolymer can be prepared in a variety of solutions each solution having progressively faster or slower solubility rate in the developer or a post development solvent in either the exposed or unexposed state.

Thus, for instance, in an electron sensitive or x-ray sensitive resist it is possible to place faster etching layers closer to the substrate and slower etching layers closer to the top and thereby (in case of a beam exposure without changing the electron beam intensity) obtain inverted V shape or T shape or vertical wall resist profiles. In addition, by practicing our invention, it is also possible to obtain much higher height to width aspect ratios without changing the e-beam intensity. This is particularly desired in view of the fact that presently it is very difficult to exposed by an e-beam, patterns smaller than 1 µ in resist thicker than ∼ 600 nm (∼ 6,000 Å) and to still obtain height to width aspect rations < 1.

The layers can be spun in any desired order. However, if the order is most soluble resist on the bottom and least soluble on the top, upon exposure one will obtain a large height to width aspect ratio and vertical wall profile.

## Claims

1. A structure comprising:
a layer (10) of resist having a first side (14) and a second side (16);
said resist having a non-uniform complexation density between said first side and said second side.

2. A structure according to claim 1, wherein said complexation density is a maximum at one of said first side and said second side and a minimum at said the other of said first side and said second side.

3. A structure according to claim 1, wherein said complexation density is a maximum or a minimum between said first side and said second side.

4. A structure according to claim 1, wherein said layer comprises a plurality of sublayers, each of said sublayer has a different complexation density.

5. A structure according to claim 1, further including an aperture between said first side and said second side.

6. A structure according to claim 5, wherein said aperture has a first opening at said first side and a second opening at said second side.

7. A structure according to claim 6, wherein said first opening is larger in size than or equal in size to or smaller in size than said second opening.

8. A structure according to claim 4, wherein each resist of said plurality of sublayers comprises the same resist with different complexation densities.

9. A structure according to claim 4, wherein each of said sublayers comprises a different resist with different complexation densities.

10. A structure according to claim 1, wherein said non-uniform complexation density is achieved by a non-uniform energy-active compound density.

11. A structure according to claim 1, wherein said resist comprises a resin and an energy active compound.

12. A structure according to claim 11, wherein said resist further includes a non-energy-active complexation agent.

13. A structure, according to claim 12, wherein said non-energy-active cross-linking agent is selected from the group consisting of hexamethyldisilazane, xylene, toluene, chlorobenzene, Triton X-100, Triton-N, IC170C and a photoactive compound.

14. A structure according to claim 11, wherein said resin is Alnoval®.

15. A structure according to claim 4, wherein each sublayer comprises a resist formed from a resin in combination with an energy-active compound, said energy-active compound having a concentration resulting in a cross-linking density for each of said sublayers, said concentration of said energy-active compound being controlled by an amount of a complexing agent-free-resin, said complexing free resin preferably being Alnoval®.

16. A structure according to claim 1, further including a substrate against which said second surface is disposed.

17. A structure according to claim 16, wherein said substrate is selected from the group consisting of a ceramic, a glass ceramic, a glass, a semiconductor and a metal.

18. A structure according to claim 10, wherein said energy-active compound is selected from the group consisting of a photoactive compound and an electron beam active compound.

19. A structure comprising:
a body of resist having a non-uniform complexation density.

20. A method comprising the steps of:
providing a substrate;
said substrate according to any one of claims 1 to 18 disposing on a layer a resist having a first side and a second side, said layer having a non-uniform complexation density between said first side and said second side.

21. A method according to claim 20, wherein said step of disposing a layer of resist on said substrate comprises disposing a plurality of sublayers on said substrate comprising spinning onto said substrate a first liquid resist layer hating said first liquid resist layer to remove solvents to form a first sublayer spinning at least one other liquid resist layer onto said first sublayer heating said at least one other liquid resist layer to remove solvents to form at least one other sublayer.

22. A method according to claim 20, wherein said aperture is formed in said layer by irradiating said layer with energy through a mask to form an irradiated layer.

23. A method according to claim 22, further including exposing said irradiated layer to developers to develop a pattern in said layer.

24. A method according to claim 23, wherein said developers are selected from the group consisting of tetramethylammonium hydroxide and potassium hydroxide.

25. A method according to claim 20, wherein said energy-active compound is sensitive to energy selected from the group consisting of electromagnetic radiation and electron beam radiation.
